# EUROPEAN PATENT APPLICATION

(11) **EP 4 607 224 A1**
(43) Date of publication of application: **27.08.2025**
(21) Application number: 24159266.6
(22) Date of filing: 23.02.2024
(51) Int. Cl.: G01R 33/381, G01R 33/3815, G01R 33/387

(54) **MAGNET ASSEMBLY COMPRISING A COIL-ARRANGEMENT**

(71) Applicant: Koninklijke Philips N.V., 5656 AG Eindhoven (NL)
(72) Inventor: FORTHMANN, Peter, Eindhoven (NL)
(74) Representative: Philips Intellectual Property & Standards

(57) **Abstract**

A magnet assembly comprising a coil-arrangement including multiple electrically conductive coils. A line-arrangement of a current supply line-assembly and a current return line-assembly passes an electrical current through the coil arrangement. The coils are rotationally arranged at an optimum magnetic field homogeneity of the coil-arrangement. By suitable rotation of the respective electrically conductive coils in their respective planes a minimum of the level of the magnetic field's spatial inhomogeneities as a function of the orientations of the electrically conductive coils is achieved. That is, an insight of the invention is that there exist(s) one or several combinations or relative orientations (orientation patterns) for which the spatial field inhomogeneity of the coil-arrangement as such is minimal.

## Description

### FIELD OF THE INVENTION

The invention pertains to a magnet assembly comprising a coil-arrangement including multiple electrically conductive coils and a line-arrangement of a current supply line-assembly and a current return supply line-assembly for passing an electrical current through the coil arrangement.

### BACKGROUND OF THE INVENTION

Such a magnet assembly is known from the European patent application EP 1 460 455**.** The known magnet assembly comprises shimming elements to achieve overall magnetic field homogeneity.

### SUMMARY OF THE INVENTION

An object of the invention is to provide a magnet assembly that is relatively simple to shim to generate a spatially uniform magnetic field. It is in particular an object of the invention to provide a magnet assembly for a magnetic resonance examination system and which is relatively easy to shim to a generate a magnetic field that is spatially uniform to a high degree, notably within the magnetic resonance examination system's examination zone. This object is achieved by the magnet assembly of the invention comprising a coil-arrangement including multiple electrically conductive coils.

A line-arrangement of a current supply line-assembly and a current return line-assembly for passing an electrical current through the coil arrangement and;
the coils being rotationally arranged at an optimum magnetic field homogeneity of the coil-arrangement.

The coil-arrangement, when activated by passing an electrical current through the electrically conductive coils, generates a magnetic field. When employed in a magnetic resonance examination system, the magnet assembly is configured such that the magnetic field is a stationary spatially uniform main magnetic field in the magnetic resonance examination system's examination zone. This stationary spatially uniform main magnetic field polarizes nuclear spins in the subject to be imaged (patient to be examined). The examination zone may be located in the bore of a solenoid type cylindrical magnet assembly or may be located between coils (coils sets) that are spatially offset transversely to the planes of the coils. In practice the magnetic field is uniform to a high degree, notably at parts-per-million (ppm) level. This high degree of spatial field homogeneity is conventionally achieved by shimming the magnet assembly by inserting shim elements in the magnet assembly that compensate for field inhomogeneities.

An insight of the present invention is that spatial inhomogeneities of the magnetic field of the magnet assembly as such (i.e. without any shim elements) are dependent on the relative orientations on the individual electrically conductive coils. An insight of the invention is that although the magnet's electrically conductive coils in principle by design have cylinder symmetry, this is in reality not the case due to manufacturing tolerances, the discrete, finite-thickness nature of the wire used and the resulting winding patterns that often have errors. To some degree rotational symmetry may be lost, and additional asymmetries may be due to random manufacturing tolerances. While the magnetic field would be invariant to coil rotation around its axis in an ideally manufactured coil, in practice asymmetries occur and a significant effect is associated with these deviations from ideal rotational symmetry of the coil. Consequently, by suitable rotation of the respective electrically conductive coils in their respective planes a minimum of the level of the magnetic field's spatial inhomogeneities as a function of the orientations of the electrically conductive coils is achieved. That is, an insight of the invention is that there exist(s) one or several combinations or relative orientations (orientation patterns) for which the spatial field inhomogeneity of the coil-arrangement as such is minimal. Without any intentional shimming, when the electrically conductive coils are mounted in the magnet assembly's frame, the magnetic field inhomogeneities are typically at a level of 500-1000ppm. When the orientational pattern corresponds with minimum field inhomogeneity as a function of the orientations of the electrically conductive coils, then predominantly high-order spatial inhomogeneities are reduced. This reduction of the level of magnetic field inhomogeneities corresponds with a reduction of the amount of shim elements for achieving the same reduction by about 15-30%, usually about 20%. Hence, when the electrically conductive coils of the coil-arrangement are orientated according to such an optimum orientation pattern, then a comparatively small effort is required (if at all) to further improve the spatial field homogeneity of the magnet assembly (as a whole) by shimming the magnetic assembly. Shimming may be done passively by inserting shim elements, usually containing iron that influence the magnetic field distribution, or actively by activating specially shim coils to generate compensating magnetic field to compensate for the magnetic field inhomogeneities of the coil-arrangement.

To activate the coil-arrangement, an electrical current is applied to the electrically conductive coils that are circuited in series. To supply the electrical current, a line-arrangement of a current supply line-assembly and a current return line-assembly is provided. The current supply line-assembly supplies electrical current from one pole of an electrical current source to the coil arrangement. The current return line-assembly carries current from the coil-arrangement to the electrical current source's opposite pole and arranges for the return connections between the electrically conductive coils so as to mutually connect electrically conductive coils circuited in series. Alternatively, the current supply line-assembly supplies electrical current from one pole of an electrical current source to the coil arrangement and arranges for the forward connections between the electrically conductive coils so as to mutually connect electrically conductive coils circuited in series. The current return line-assembly carries current from the coil-arrangement to the electrical current source's opposite pole.

The invention achieves to set-up the coil-arrangement according to an orientation pattern for which the field homogeneity of the coil -arrangements in as far as depending on the orientations of the electrically conductive coils is optimal. Thus, a smaller effort is required for finally shimming the magnet assembly as a whole to produce a spatial uniform magnetic field , notably in the examination zone. This small effort usually involves the insertions of only a few shim elements of a simple correction by activation of only a few shim coils. This reduces manufacturing cost and effort for manufacture of a magnet assembly with good magnetic field homogeneity. In the orientation pattern for which the field inhomogeneity as a function of the coil orientations is minimum, especially spatially high order magnetic field inhomogeneities are significantly reduced. These spatially high-order magnetic field inhomogeneities are notoriously difficult to correct by conventional shimming techniques using shim elements inserted in the magnet assembly. Further, shimming efforts may be required to compensate for axial misplacement of the coils when mounted in the magnet assembly's frame. When employed in a magnetic resonance examination system, the magnet assembly of the invention contributes to improved image quality in that a low level of image artefacts associated with magnetic field inhomogeneities is achieved, notably without the need of an extensive shimming process.

These and other aspects of the invention will be further elaborated with reference to the embodiments defined in the dependent Claims.

In a practical embodiment of the magnet assembly, each electrically conductive coil has a forward-port and a return-port for passing an electrical current through the electrically conductive coil. The current supply line-assembly includes a forward electrical conductor line to the forward port of one of the electrically conductive coils. The forward electrical conductor line is configured to be coupled at one end to one pole of an electrical current source and at its opposite end coupled to the forward port of one of the electrically conductive coils. The current return-line assembly includes one or more internal return electrical conductor lines between respective electrically conductive coils, coupled between the return port and the forward port to the respective different electrically conductive coils. These internal return electrical conductor lines extend within the coil-arrangement. The current return line-assembly incudes an external return electrical conductor line from the return port of one of the electrically conductive coils. The external return electrical conductor line extends (partly) outside of the coil-arrangement. The external return electrical conductor line is configured to be coupled to the current source's opposite pole and to the return port of one of the electrically conductive coils. In this way the line-arrangement provides for a series circuit of the electrically conductive coils. The electrical current source may be incorporated in the magnet assembly or may be implemented as an external unit with the line-arrangement being configured to couple the coil-arrangement to the external current source. When the electrically conductive coils are superconductive the electrical current source may be detached from the coil-arrangement when the coil-arrangement operates in its persistent mode.

In the coil-assembly, the electrical current is introduced to one of the electrically conductive coils over its forward-port by a forward electrical conductor line from one pole of the electrical current supply. The electrical current exits this electrically conductive coil over its return-port to another, neighboring or adjacent electrically conductive coil over an internal return electrical conductor line to the forward port of that neighboring or adjacent electrically conductive coil. The individual electrically conductive coils are circuited in series in that internal return electrical conductor lines connect the return port of one electrically conductive coil to the forward port on the next electrically conductive coil. Thus, the internal return electrical conductor lines form a daisy-chain connection between the electrically conductive coils forming the series connection. The external return electrical conductor line extends further from one (usually at one end of the coil-arrangement) electrically conductive coil to the opposite port of the electrical current source. The current supply line-assembly and the current return line-assembly are spatially arranged along aligned adjacent paths or as twisted wires within the coil-arrangement. Because, in operation, oppositely directed electrical currents pass through the current supply line-assembly and the current return line assembly, and the electrical conductor lines of these line-assemblies are close to each other, in particular within the coil-arrangement, the magnetic fields induced by these opposite electrical currents cancel, and decay radially away form the electrical conductor lines. In this way contributions to the field inhomogeneity by the electrical currents in the line-arrangement are to a large extent or even almost completely cancelled. Hence, at most only a low level of residual magnetic field is generated by the electrical current in the line-arrangement within the coil-arrangement. Good results are achieved when the current supply line-assembly and the current return line assembly are within a range of 0.5-1.5cm apart, notably within the coil-arrangement. Any residual field inhomogeneity may be compensated for by taking it into account in the optimum orientation pattern of the electrically conducting coils.

In particular, the internal return electrical conductor lines are aligned with and next to or forming twisted wire pairs with the forward electrical conductor line at least in as far is it extends with the coil-arrangement. Further reduction of the residual magnetic field due to the electrical currents in the line-arrangement may be achieved by also aligning the external return electrical conductor line and the forward electrical conductor line at least in as far as it extends outside of the coil-arrangement.

The functions of the electrical current supply lines and the electrical current return lines may be re-arranged in that the electrical current is introduced to one of the electrically conductive coils over its forward-port by an external forward electrical conductor line from one pole of the electrical current supply. The electrical current exits this electrically conductive coil over its return-port to another, neighboring or adjacent electrically conductive coil over an internal forward electrical conductor line to the forward port of that neighboring or adjacent electrically conductive coil. These internal forward electrical conductor lines extend within the coil-arrangement. The individual electrically conductive coils are circuited in series in that internal forward electrical conductor lines connect the return port of one electrically conductive coil to the forward port of the next electrically conductive coil. Thus, the internal forward electrical conductor lines form a daisy-chain connection between the electrically conductive coils forming the series connection. An external return electrical conductor line extends further from one (usually at one end of the coil-arrangement) electrically conductive coil to the opposite port of the electrical current source.

In this way contributions to the magnetic field inhomogeneity by the electrical currents in the current supply line-assembly and the current return line-assembly are to a large extent, or even almost completely cancelled. In particular, the internal forward electrical conductor lines are aligned with and next to the return electrical conductor line in as far is it extends within the coil-arrangement. Further reduction of the residual magnetic field due to the electrical currents in the line-arrangement are achieved by also aligning the external forward electrical conductor line and the return electrical conductor line in as far as it extends outside of the coil-arrangement.

The rearrangement of the functions is associated with a reversal of the direction of the stationary uniform magnetic field.

Two or more of the forward-port and return-port pairs of the respective electrically conductive coils are azimuthally differently orientated in the coordinate frame of the coil-arrangement or of the magnet assembly, representing the orientational pattern of the electrically conductive coils that minimizes the magnetic field inhomogeneities as a function of the orientation pattern. In this embodiment the electrically conductive coils can be mounted in the frame of the magnet assembly with the forward port and the return port being provided on each of the electrically conductive coil before mounting in the frame.

In another embodiment of the magnet assembly of the invention, the compensation for magnetic field inhomogeneities is limited to non-zonal (tesseral) components. In general, the magnetic field inhomogeneities can be categorized into zonal and non-zonal (sectoral and tesseral) components. The zonal components of the magnetic field inhomogeneities are independent of the azimuthal angle, i.e. the orientation of the electrical coil in its plane and would therefore not change with rotation of a coil around the longitudinal axis transverse to the plane of the coil. Zonal field errors are mainly due to axial (longitudinal) displacement of windings, and, of course, whole coils relative to each other. Longitudinal displacements of 0.1-1,0mm already give rise to significant field inhomogeneities. This aspect of the invention aims at reduction of the non-zonal terms, which do have an angular dependence. On the basis of the characteristics of the electrically conductive coils of the coil-arrangement, there is an optimum set of rotations, i.e. the optimum orientation pattern in which the inhomogeneities superpose in a beneficial (i.e. in a destructive interference) way that minimizes the amount of (iron) shim elements needed for final shim. This improves the field homogeneity of the magnet-assembly without the need of extensive passive or active shimming by providing shim elements, separate shim coils or configure the magnetic resonance examination system's gradient system to also compensate for magnetic field inhomogeneities. Some shimming activity, however, may still be required to compensate for any axial misplacement of the coil.

In an embodiment of the invention, the rotational arrangement of the coils when in operation compensates for residual magnetic fields induced by the line-arrangement. The electrical currents in the current supply and current return lines cause spatially inhomogeneous magnetic fields when the coil-arrangements are activated. These induced spatial inhomogeneities of the magnetic field of the coil-arrangement may be compensated for by the rotational arrangement of the electrically conductive coils. That is the coil orientation pattern associated with the optimum magnetic field homogeneity may be arranged so that the spatial inhomogeneities due to the electrical currents in the line-arrangement are taken into account when achieving the optimum orientation pattern.

The invention further pertains to a method for measuring the spatial magnetic field distribution of the magnet assembly of the invention. A field camera to map the magnetic field distribution of a magnetic resonance examination system is known per se from the European patent application EP 2 515 132**.** The measurement method of the invention can be carried-out while a current strength of less than the magnet assembly's nominal operational electrical current strength, notably less than 10A, is passed through the magnet assembly's electrically conductive coils. The nominal operational current strength represents the electrical current strength that is associated with the nominal operational field strength of the magnet assembly and are typically in the order of several 100A or even in the order of 1kA. When employed in a magnetic resonance imaging system for diagnostic imaging, the nominal magnetic field strength may be 0.6T for mid-field strength, 1.5T, 3.0T, for high field strength or 7T at ultra-high field strength. Because the magnetic field strength is measured at comparatively very low electrical current, the measurement may be made while the electrically conductive coils are in a normal resistive state, i.e. not superconducting. Thus, for achieving the optimum orientation pattern of the electrically conductive coils, there is no need to cool the electrically conductive coils to temperatures below the critical temperature for superconductivity of the material of the electrically conductive coils.

Accurate results of the magnetic fields strengths with a low electrical current strength in the electrically conductive coils are obtained, when the field strength is measured in close proximity to the conductors of the electrically conductive coils. These measurements of the magnetic field close to the electrical conductor of the coil have a good signal-to-noise ratio. It appears that on the basis of these measurements that involve little decay of the field strengths at small distance to the conductors and hence a good signal-to-noise ratio, the field strengths distribution of the coil-arrangement may be computed reliably. Close to the coil conductor the magnetic field generated by the low electrical current is not much decayed. Further, when the measurement of the field strength is done with also several or all other electrically conducting coils mounted in the frame of the magnet assembly, at the position of the measurement of the field strength close to the electrical conductor of one electrically conducting coil, there is a relatively large distance to the windings of the other electrically conductive coils that are further away from the measurement position of which the magnetic field is strongly decayed. When the magnetic field is measured with several or all of the electrically conductive coils already assembled into the magnet assembly, the field of one particular coil is best measured very close to the coil as there will be field contributions of the other electrically conductive coils of which the influence is then minimized because the distance is then maximized to these other electrically conductive coils contributing to the magnetic field of the electrically conductive coils carrying a low electrical current. The optimum positions close to the coil windings for measurement of the magnetic field strength may be determined experimentally empirically without much additional effort. The positions may be at most a few cm away from the winding. In practice the distance to the winding to be measured is significantly, e.g. one or more orders of magnitude less than the axial separation of adjacent electrically conductive coils

In another implementation of the measurement method, the measurements of the magnetic field strengths generated by the electrical current passed through the electrically conductive coils are carried-out on the individual electrically conductive coils. That is, the measurements are made while the electrically conductive coils not mounted in the magnet assembly, but separately. For example, the measurement method may be implemented in that the coil may be energized while it is still on the winding mandrel. Using one or more stationary field detector(s) close to the coil, its magnetic field (asymmetry) can be very well measured. On the basis of the magnetic field strength measured for the individual electrically conductive coils, the spatial distribution of the magnetic field strength in the magnet assembly and hence the inhomogeneities of the magnetic field of the magnet assembly may be computed or simulated. These computations or simulations involve a transformation of the measured magnetic fields strengths of the electrically conductive coils at low electrical current to the configuration of the electrically conductive coils in the magnet assembly and also a transfer to the magnetic field strengths at the nominal electrical current for the nominal field strength of the magnet assembly. Measurement of the magnetic field strength of the individual electrically conductive coils is generally less cumbersome than performing the measurements while the electrically conductive coils are mounted in the coil-arrangement. Notably, it is easier to reach measurement positions close to the coil conductor where the magnetic field strength is relatively high. For a separate electrical coil conductor it is simpler to place NMR-based probes for sensing the magnet field strength at positions where measurements of the magnetic field strengths while a low electric current is passed though the coil conductor can be made with a good signal-to-noise ratio. Such measurements provide a good basis for computation or simulation of the resulting magnetic field strength distribution of the coil arrangement with the electrically conductive coils in position in the coil arrangement.

Performing the measurements of the magnetic field strength distribution of the electrically conductive coil or of the coil-arrangement as a whole at room temperature may be easier because the coil-arrangement need not be placed inside a cryostat to keep the material of the coil conductors below their superconductivity critical temperature. Hence, access is easier to useful positions where the magnetic field strength can be reliably measured. These measurements at room temperature require that the temperature difference between room temperature and operational temperature of the magnet assembly between the superconductivity critical temperature are taken into account when calculating or simulation of the magnetic field strength distribution at temperature below the critical temperature for superconductivity.

The invention also pertains to a computational method of a coil orientation pattern associated with the optimum magnetic field homogeneity of the coil arrangement from the magnetic field distribution measured or computed or simulated from the measured magnetic field strengths of the individual electrically conductive coils. A more sophisticated computational method may account for the residual magnetic fields induced by the line-arrangement for the supply and return of the electrical current though the coil-arrangement. In another advanced computational method the computation of the magnetic field inhomogeneity of the coil-arrangement from the measurements of the magnetic field strength distribution of either the coil-arrangement or based on measurements of the magnetic field strength distribution of the individual electrically conducting coils separately, account is taken of thermal and mechanically induced deformation, contraction or expansion of the components of the magnet assembly with the electrically conductive coils mounted in the coil-arrangement.

These and other aspects of the invention will be elucidated with reference to the embodiments described hereinafter and with reference to the accompanying drawing wherein

### BRIEF DESCRIPTION OF THE DRAWINGS

Fig. 1 shows a diagrammatic representation of an example of a magnet assembly of the invention;
Fig. 2 shows a diagrammatic side-elevation of a magnetic resonance examination system incorporating the magnet assembly of the invention;
Fig. 3 shows a flow-chart of the procedure for setting up the magnet assembly of the invention;
Fig. 4 shows a diagrammatic representation of another example of a magnet assembly of the invention.

### DETAILED DESCRIPTION OF THE EMBODIMENTS

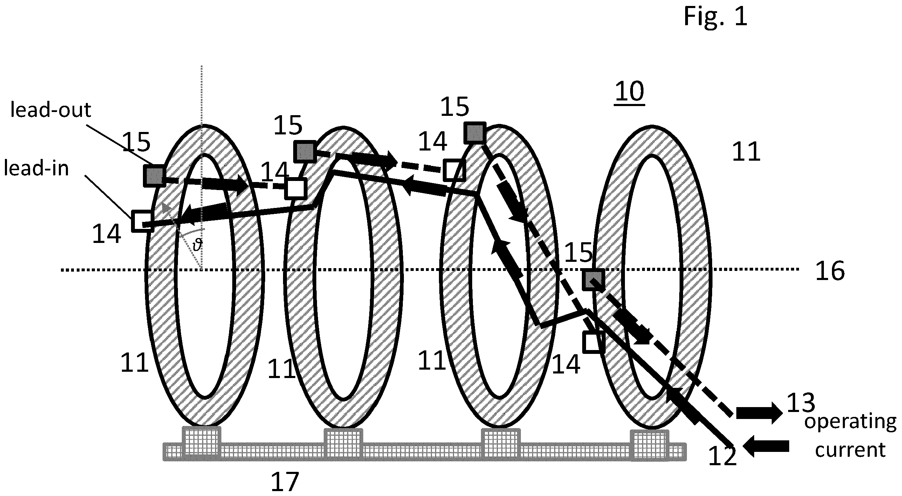

Fig. 1 shows a diagrammatic representation of an example of a magnet assembly of the invention. The magnet assembly 10 comprises several, in this example four, electrically conductive coils 11 that are aligned along a common longitudinal axis 16 in a cylindrical configuration mounted on the support frame 17 of the magnet assembly . The electrically conductive coils 11 may be electrically resistive or they may be made with superconducting material, so that when cooled below the critical temperature for the material, the electrically conductive coils have no resistances and a persistent electrical current may pass through the electrically conductive coils 11. In another example, electrically conductive coils 11 may be superconductive themselves, while they are interconnected and connected to an electrical current source by electrically resistive joints . Such a magnet assembly may be driven in a non-persistent mode that requires continuous supply of an electrical current with relatively low current strength. The electrically conducting coils are circuited in series by a line-arrangement formed by the current supply line assembly including the forward electrical conductor lines 12 and the current return line assembly including the internal return electrical conductor lines 13. That is the forward electrical conductor line is segmented as several forward electrical conductor lines 12 and the return electrical conductor line is segmented as several return electrical conductor lines. The electrically conductive coils 11 are interconnected by the internal return electrical conductor lines 13 and the forward electrical conductor lines 12 run from the electrical current source to a forward port on the of the electrically conductive coils 11. When in operation, the constant (DC) electrical current runs in the electrically conducting coils 11, and then the magnet assembly 20 generates a stationary magnetic field. The portion of the stationary magnetic field in the bore 27 is spatially uniform and is suitable for magnetic resonance imaging. In the case of a superconducting magnet that operates in persistent mode, the electrical current supply source is disconnected from the coil-arrangement 11 and the current return line assembly shorted with the current supply line-assembly at their ends outside the coil-arrangement by way of a magnet persistent current switch known per se from the international application WO2022/073768.

The functions of the current supply line-assembly and the current return line-assembly may be interchanged in that the internal forward electrical conductor lines interconnect the electrically conductive coils 11 and the return electrical current line supports the connection of the electrical current source with the coil-arrangement of the electrically conductive coils 11 . The interchange of the functions is associated with a reversal of the direction of the stationary magnetic field. Each of the electrically conductive coils is provided with a forward port 14 and a return port 15. The electrical current is introduced into the electrically conductive coil 11 at is forward port 14 and leaves the electrically conductive coil 11over the return port 15 to the return electrical conductor line 12 to the forward port 14 of the adjacent electrically conductive coil 11. In this way, the electrically conductive coils 11 are circuited in series and the electrical current passes through the electrically conductive coils and returns the electrical current source, or, when in persistent mode the electrically current return line at one end is shorted to the electrically current supply lines. The electrically conductive coils may include superconducting windings of e.g. NbTi-compounds or high-temperature superconducting material such as MgB₂ or YbaCuO-type cuprates.

As is shown in Fig. 1 with respect to the coordinate frame of the coil-arrangement, the orientations 0 of the individual electrical coil 11 may be different in that the electrically conductive coils 11 are mutually rotated about the longitudinal axis 17 and in the plane of the respective coil. The mutual circumferential orientations of the electrically conductive coils 11 about their axes of symmetry are arranged so that the spatial inhomogeneities of the magnetic field is minimal.

As further shown in Fig. 1, the forward electrical conductor line 13 and the internal return electrical conductor lines 12 are arranged along paths along which the forward electrical conductor line and internal return electrical conductor lines, 12,13 are at close radial (with respect to the length of the lines) separation from each other and run next to each other along to a large extent geometrically parallel of twisted-pair trajectories throughout the coil-arrangement. That is, throughout the coil-arrangement the directions of the electrical supply and return currents 12,13 are in direction that are within a narrow directional range of 0.5-1.5cm relative to each other. The forward and internal return electrical conductor lines may be simply held together mechanically, e.g. by tie wraps. As the transverse or radial separation of the forward electrical conductor lines and the internal return electrical conductor lines 12,13 relative to each other is small about 0.5cm or less, the net additional magnetic field generated by the electrical current supply and return lines (almost) cancels and hardly or not at all adds to inhomogeneities of the stationary magnetic field generated by the electrically conductive coils 11. In another implementation the relative orientations of the electrically conductive coils 11 and the relative locations and orientations of the forward electrical conductor lines and the internal return electrical conductor lines 12,13 are arranged such that the additional net magnetic field contributions generated by the line-arrangement (almost) cancels the inhomogeneities of the stationary magnetic field contributions generated by the coil-arrangement. Thus, the residual magnetic field inhomogeneities of the magnet assembly may be compensated to a large extent or even completely. Accordingly, at most a small amount of additional shimming by conventional passive shim elements or active shim coils may be required.

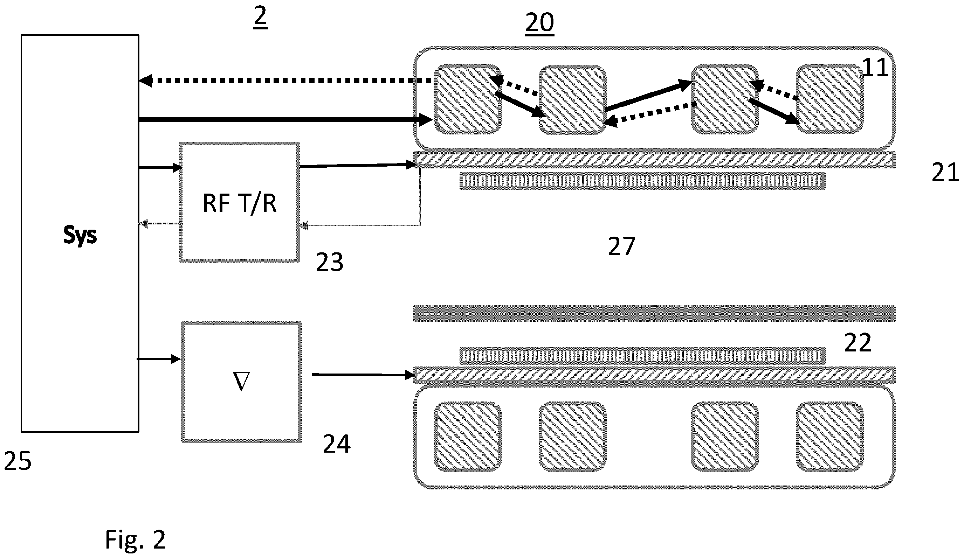

Fig. 2 shows a diagrammatic side-elevation of a magnetic resonance examination system 2 incorporating the magnet assembly of the invention. The magnetic resonance examination system 2 comprises the magnet assembly 11 of the invention. Further a radio frequency (RF) system 21,23 including an RF transmit and receive (T/R) antenna system 21 is provided in the magnetic assembly 20 and a RF T/R amplifier 23. Further a gradient system is provided with a magnetic gradient coil 22 and a gradient amplifier 24. The gradient system generates gradient magnetic field pulses for spatially encoding spins in the tissue of a patient to be examined placed on a patient support 26 in the examination zone in which the magnet assembly generates the stationary magnetic field. The RF T/R system generates RF pulses for manipulation of the spins. Together the RF T/R system and the gradient system generate magnetic resonance signals that are spatially encoded and which carry image information of the patient's body. Magnetic resonance images are reconstructed from the magnetic resonance signals by a reconstruction module that is incorporated in the system control (software) 25. The system control further controls the operation of the RF T/R system and the gradient system according to MR imaging protocols including one or several MR acquisition sequences of RF and gradient pulses.

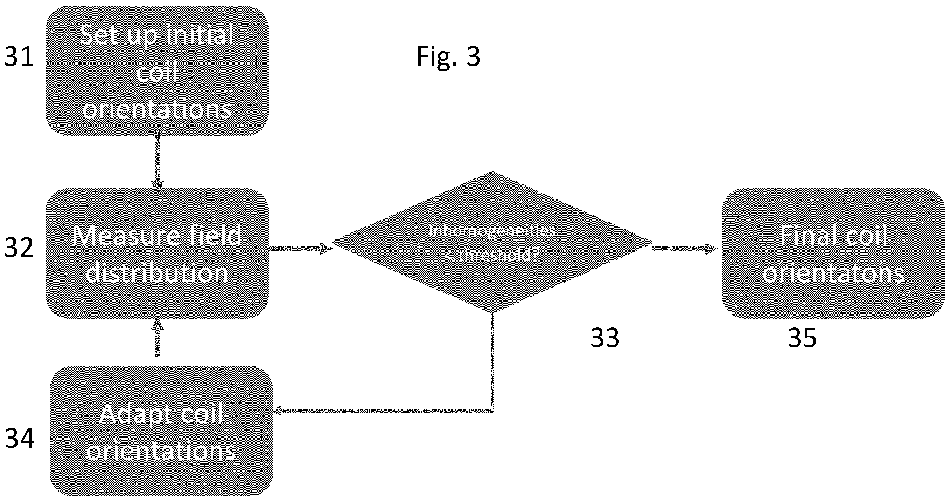

Fig. 3 shows a flow-chart of the procedure for setting up the magnet assembly of the invention. The procedure starts at set-up 31 initial coil orientations of the electrically conductive coils. The spatial magnetic field distribution for the initial set up is measured 32 for a number of different mutual orientations and finally the electrically conductive coils 13 are fixed in an orientations pattern that minimizes the field error 33. In the event that the measured magnetic field inhomogeneities are not within the acceptable predetermined range, the coil orientations are adapted 34 and the spatial magnet field distribution is measured again for the adapted coil orientations. This portion of the procedure may be iterated. When the magnetic field inhomogeneities are within the acceptable range then the associated coil orientations pattern is set 35 as the final coil orientation pattern. In a different approach, a low electric current of about 10A or less is passed through the coil windings while the coil is still on the mandrel and the generated field strengths are measured near the windings. Form these measured field strengths a field map of the magnetic field of each individual electrically conductive coil is calculated. From the field maps of the respective electrically conductive coils and the geometry of the coil-assembly, i.e. as mounted to the support frame of the magnet assembly can be calculated or simulated. The electrically conductive coils may then be mounted, e.g. in the support frame 17 of the magnet assembly, according to this final coil orientation pattern. The measurement of the magnetic field distribution may be performed at relatively low electrical current through the coil-assembly, i.e. at one or several orders of magnitude less than the electrical current through the coil-assembly during nominal operation of the coil-assembly generating a magnetic field strength typically of 1.5T or 3.0T. The measurements of the magnetic field distribution may be carried out with the line-arrangement of the series circuiting of the electrically conductive coils in operation. Accordingly, the measured magnetic field distribution accounts for any net magnetic field components from the line-arrangement in which the electrical currents in the current supply line-assembly and the current return line-assembly may not precisely cancel. Then the final coil orientation pattern is such that the residual magnetic field inhomogeneities of the electrically conductive coils themselves and of the line-arrangement compensate or even cancel completely.

The comparison of the measured magnetic field inhomogeneities to the pre-determined acceptable range, the ensuing adaptation of the coil orientation pattern may be computer-implemented. To that end, the computer programme of the invention may be ran on a computer that controls the procedure for setting up the magnet assembly of the invention.

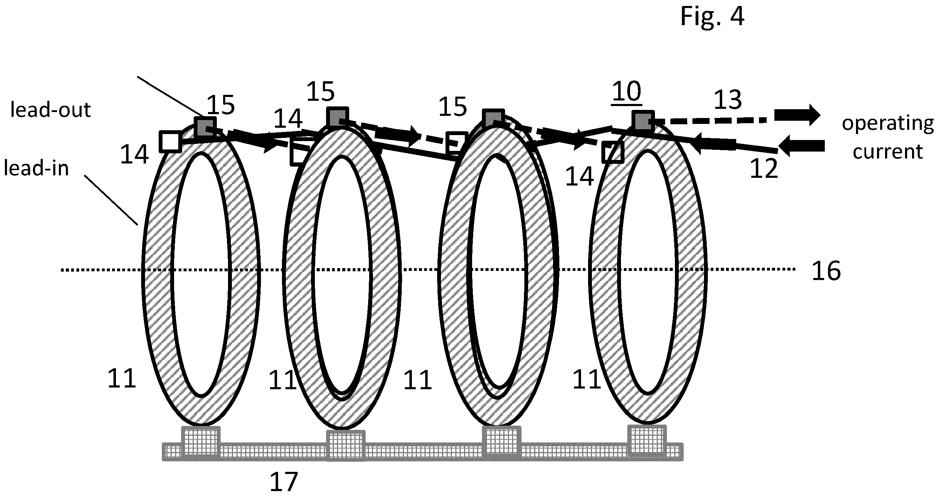

Fig. 4 shows a diagrammatic representation of another example of a magnet assembly of the invention. In this example, the forward/return port 14,15 pairs of the electrically conductive coils 11 are with respect to the coordinate frame of the coil arrangement orientated equally circumferentially within a narrow azimuthal margin, e.g. associated with measurement accuracy and manufacturing tolerances. Consequently, the current supply and return line-assemblies 12,13 run (almost) parallel and longitudinally along the coil-arrangement, at least within the coil arrangement. In this way the routing of the line-arrangement is simpler and more accurate as to compensation of the magnetic field components generated by the electrical current through the current supply line-assembly and the current return line-assembly. In this example, the electrically conductive coils 11 are orientated in the orientational pattern for which the magnetic field inhomogeneities are minimal. Subsequently the forward (lead-in)/return(lead-out) ports 14,15 are created and longitudinally aligned with the electrically conductive coils in the optimum orientational pattern. In order to provide circumferential margin for making the forward/return ports with the electrically conductive coils maintained in the optimum orientational pattern, the winding of the wire of the electrically conductive coils is adapted. Winding of the wire is done on a rotating coil-former or mandrel and at the start of the winding process the wire is secured to the coil-former while an initial length of wire of the circumferences of the coil is left free and the wire is secured to the coil-former at a position about this length from one end of the wire. At the end of the winding process, the wire is secured to the coil former, leaving another final length of wire from the secured end-point, again of about a circumferential length of the coil. These initial and final lengths may be arranged as additional windings formed at the start and end of the winding processes, respectively.

These initial and final windings are supported on the coil former in such a way that they can be accessed after completion of the winding process and portion be cut off, and the forward and return ports formed at the ends of the cut of initial and final windings.

## Claims

1. A magnet assembly comprising
a coil-arrangement including multiple electrically conductive coils,
a line-arrangement of a current supply line-assembly and a current return line-assembly for passing an electrical current through the coil arrangement and
the coils being rotationally arranged at an optimum magnetic field homogeneity of the coil-arrangement.

2. A magnet assembly as claimed in Claim 1, wherein
the current supply and current return assemblies' electrical conductor lines are aligned along adjacent paths within the coil-arrangement.

3. A magnet assembly as claimed in Claim 2, wherein each electrically conductive coil has a forward-port and a return-port for passing an electrical current through the electrically conductive coil, and
the current supply line-assembly includes a forward electrical conductor line to the forward port on one of the electrically conductive coils and
the current return line assembly includes
one or more internal return electrical conductor lines between the return port and forward port of respective different electrically conductive coils and
an external return electrical conductor line from the return port on one of the electrically conductive coils.

4. A magnet assembly as claimed in Claim 2, wherein each electrically conductive coil has a forward-port and a return-port for passing an electrical current through the electrically conductive coil, and
the current supply line-assembly includes
an external forward electrical conductor line to the forward port of one of the electrically conductive coils and
one or more internal forward electrical conductor lines between the return port and forward port of respective different electrically conductive coils and
the current return line-assembly includes a return electrical conductor line from the return port on one of the electrically conductive coils.

5. A magnet assembly as claimed in any one of Claims 3 or 4, wherein
two or more of the forward-port and return-port pairs of the respective electrically conductive coils being azimuthally differently orientated, such that the inhomogeneity of the magnetic field generated by the electrically conductive coils is minimized as depending on the orientations of the electrically conductive coils.

6. A magnet assembly as claimed in Claim 1, wherein the coils are axially offset along the assembly's longitudinal axis and extend transversely to the longitudinal axis.

7. A magnet assembly as claimed in any one of Claims 1 to 6, wherein the optimum magnetic field homogeneity is optimized for non-zonal contributions to the magnetic field distribution that are independent of the electrically conductive coils' axial positions.

8. A magnet assembly as claimed in Claim 1, wherein the rotational arrangement of the coils when in operation compensates for residual magnetic fields induced by electrical currents in the current supply-line assembly and the current return line-assembly.

9. A measurement method for measuring a spatial magnetic field strength distribution of the magnet assembly of any one of Claims 1 to 8, the method comprising
performing measurements of the magnetic field strength distribution while an electrical current of a current strength of less than the magnet assembly's nominal operational current strength, notably less than 10A, is passed through the magnet assembly's electrically conductive coils.

10. A measurement method for measuring a spatial magnetic field strength distribution of the magnet assembly of any one of Claims 1 to 8 the method comprising performing the measurements of the magnetic field strength distribution at close distance to the electrically conductive coils.

11. A measurement method for measuring a spatial magnetic field strength distribution of the magnet assembly of any one of Claims 1 to 8, wherein the measurements of the magnetic field strength distribution are carried-out for respective individual electrically conductive coils prior to their mounting in the magnet assembly.

12. A measurement method for measuring a spatial magnetic field strength distribution of the magnet assembly of any one of Claims 1 to 8, wherein the measurements of the magnetic field strength distribution are carried-out at room temperature.

13. A computational method of a coil orientation pattern associated with the optimum magnetic field homogeneity of the coil-arrangement for the magnetic assembly of any one of Claims 1 to 8, from a measured or computed spatial magnetic field strength distribution.

14. A computational method of Claim 13, wherein the computation takes account of thermally and/or mechanically induced deformation, contraction expansion of components of the magnet assembly.

15. A computer programme comprising instructions to perform the computational methods of Claim 13 or 14.
